# EUROPÄISCHE PATENTSCHRIFT

(11) **EP 2 297 792 B1**
(45) Veröffentlichungstag und Bekanntmachung des Hinweises auf die Patenterteilung: **19.06.2019**
(21) Anmeldenummer: 09777248.7
(22) Anmeldetag: 16.07.2009
(51) Int. Cl.: H01L 31/18, H01L 31/0352, H01L 31/042

(54) **SOLARZELLENCHIPS MIT NEUER GEOMETRIE UND VERFAHREN ZU DEREN HERSTELLUNG**
SOLAR CELL CHIPS WITH NOVEL GEOMETRY AND METHOD FOR THE PRODUCTION THEREOF
PUCES DE CELLULES SOLAIRES PRÉSENTANT UNE NOUVELLE GÉOMÉTRIE ET PROCÉDÉ DE FABRICATION

(30) Priorität: 16.07.2008 DE 102008033352
(43) Veröffentlichungstag der Anmeldung: 23.03.2011
(73) Patentinhaber: Saint-Augustin Canada Electric Inc., Saint-Augustin de Desmaures, Québec G3A 1S5 (CA)
(72) Erfinder: VAN RIESEN, Sascha, 79114 Freiburg (DE); GOMBERT, Andreas, 79100 Freiburg (DE)
(74) Vertreter: Grünecker Patent- und Rechtsanwälte PartG mbB
(86) Internationale Anmeldenummer: PCT/EP2009/005189
(87) Internationale Veröffentlichungsnummer: WO 2010/006798

(56) Entgegenhaltungen:
- WO-A1-2008/112310
- DE-U1- 20 112 309
- JP-A- 2001 094 127
- US-A- 4 089 705
- US-A- 5 460 659
- US-A- 6 030 885
- US-A1- 2007 074 756
- US-A1- 2008 135 095

## Beschreibung

Die Erfindung betrifft Solarzellenchips mit einer neuen Geometrie für Konzentratoranwendungen und ein Verfahren zur Herstellung derartiger Solarzellenchips. Die Geometrie der Solarzellenchips wird dabei so gewählt, dass ein kontinuierlicher Schneidevorgang mittels Laser bei der Vereinzelung der Chips aus dem Wafer ermöglicht wird.

In der Konzentrator-Photovoltaik ("concentrator photovoltaics - CPV) wird die direkt einfallende Solarstrahlung durch eine Konzentratoroptik auf eine Solarzelle gebündelt, so dass auf der Zelle die Bestrahlungsstärke um den sogenannten Konzentrationsfaktor höher ist. Zur Ausgestaltung der Konzentratoptik gibt es eine Vielzahl von optischen Ansätzen, die in der Regel auf Brechung, Reflexion oder interner Totalreflexion an speziell geformten optischen Komponenten beruhen (P. Benitez und J.C. Minano, "Concentrator optics for the next-generation photovoltaics", in A. Marti und A. Luque (Ed.), "Next Generation Photovoltaics", Institute of Physics Publishing, Series in Optics and Optoelectronics, Bristol and Philadelphia, ISBN 0750309059, 2004). Bei hoch konzentrierenden Systemen, d.h. Konzentrationsfaktor >50, wie sie im Folgenden ausschließlich betrachtet werden, ist es auch üblich, die optische Konzentration in zwei Stufen zu erwirken, durch einen Primär-und einen Sekundärkonzentrator. Der Sekundärkonzentrator hat wiederum verschiedene Ausführungsformen unter Nutzung der o.g. optischen Effekte. Er kann dazu dienen, die Konzentration zu erhöhen, den Winkelbereich, unter dem die Solarzelle Strahlung empfängt, zu vergrößern und sie homogener über die Zellfläche zu verteilen. Bei der Homogenisierung ist es auch möglich, den Querschnitt des Strahlungsbündels zu beeinflussen. Als Solarzellen eignen sich besonders solche, welche einen sehr hohen Wirkungsgrad aufweisen, da dadurch der technische Aufwand für die optische Konzentration und für die inhärent verknüpfte Nachführung des Systems gerechtfertigt werden kann. Dies können hocheffiziente Si-Solarzellen, z.B. Rücckontakt-Solarzellen, aber vor allem auch monolithisch verschaltete Stapelsolarzellen auf der Basis von III-V Halbleitermaterialien (engl. Multijunction Cells, MJC) sein. Multilayerstrukturen aus III-V Verbindungshalbleitern werden epitaktisch gewachsen. Eine typische Struktur einer Tripelzelle hat eine Germanium-Basiszelle, eine GaInAs-Mittelzelle und eine GaInP-Topzelle. Germaniumwafer sind die Substrate, auf die die dünnen III-V Halbleiterschichten abgeschieden werden. Sowohl das Grundmaterial als auch die Herstellung von MJC ist kostenintensiv, weshalb generell davon ausgegangen wird, dass eine sehr hohe Konzentration, d.h. kleine Zellflächen bezogen auf die solare Apertur, für die Wirtschaftlichkeit der CPV notwendig ist (C. Algora, "The importance of the very high concentration in third-generation solar cells", in A. Marti and A: Luque (Ed.), "Next Generation Photovoltaics", Institute of Physics Publishing, Series in Optics and Optoelectronics, Bristol and Philadelphia, ISBN 0750309059, 2004).

Das Problem dabei ist, kostenintensive Wafer mit sehr hocheffizienten Solarzellen für Konzentrator-Photovoltaik so effizient wie möglich auszunutzen, um eine wirtschaftliche Nutzung dieser Technologie zu ermöglichen.

Stand der Technik ist es, die hocheffizienten Solarzellen auf Wafern zu prozessieren und anschließend in rechteckige, meist quadratische, Chips durch Sägen zu vereinzeln. Die Einzelchips haben dann typischerweise Kantenlängen von 1 bis 10 mm.

Nahezu alle der eingesetzten optischen Primärkonzentratoren erzeugen einen weitgehend rotationssymmetrischen Brennfleck. Ohne Sekundärkonzentrator ist daher die nutzbare aktive Fläche der Konzentrator-Solarzellen ebenfalls rotationssymmetrisch. Die Ecken der in diesem Fall quadratischen Zelle werden als Bondflächen für die elektrische Verschaltung der Zelle genutzt. Insgesamt ist aber die Nutzung des teuren Wafermaterials bei rechteckiger, insbesondere quadratischer Geometrie und kreisförmiger aktiver Zellfläche nicht zufriedenstellend. Unter Einbeziehung von Flächenverlusten durch Sägeschnitt und Waferrand können kaum mehr als 60% der Waferfläche als aktive Solarzellenfläche genutzt werden. Bei Zellgrößen unter 2 mm nimmt die nutzbare Fläche aufgrund von Schnittverlusten drastisch ab.

Ein Sekundärkonzentrator kann wie ein Kaleidoskop durch Mehrfachreflexionen die Strahlung homogener auf eine rechteckige Ausgangsfläche verteilen. Solche Sekundärkonzentratoren sind aus der Literatur bekannt (J.M. Gordon, "Concentrator optics", in A. Luque and V. Andreev (Eds.), Concentrator Photovoltaics, Springer Series in Optical Sciences 130, Springer-Verlag, Berlin Heidelberg (2007) und US 2008/0087323 A1) und können demgemäß eine kreisförmige Eintritts- und eine nahezu rechteckige Austrittsfläche oder jeweils rechteckige Flächen aufweisen. Allerdings müssen diese Sekundärkonzentratoren bei relativ großem Höhenzu Seitenverhältnis extrem verlustfrei sein, d.h. einen sehr hohen Reflexionsgrad aufweisen und im Falle massiver Systeme aus einem transparenten Material sehr geringer Absorption sein. Solche Sekundärkonzentratoren sind heute nur zu hohen Kosten herstellbar.

US 2008/0135095 A1 offenbart ein Verfahren zur Herstellung von Solarzellenchips für Konzentratoranwendungen, wobei mittels eines Lasers aus einem Wafer Chips mit einer von der rechteckigen Form abweichenden Geometrie geschnitten werden.

In der US 6 030 885 A wird ein Verfahren zur Herstellung von Halbleiterchips beschrieben, in dem mittels eines Lasers aus einem Wafer Chips geschnitten werden.

Ausgehend hiervon war es Aufgabe der vorliegenden Erfindung, ein Verfahren zur Herstellung von Solarzellenchips bereitzustellen, das eine bessere Ausnutzung der Waferfläche, insbesondere bei Verwendung von Sekundärkonzentratoren, ermöglicht. Gleichzeitig soll der Herstellungsprozess einfach zu handhaben und kostengünstig sein.

Diese Aufgabe wird durch das Verfahren zur Herstellung von Solarzellenchips mit den Merkmalen des Anspruchs 1, den Solarzellenchip mit den Merkmalen des Anspruchs 7 und das Solarzellenmodul mit den Merkmalen des Anspruchs 8 gelöst. Die weiteren abhängigen Ansprüche zeigen vorteilhafte Weiterbildungen auf.

Erfindungsgemäß wird ein Verfahren zur Herstellung von Solarzellenchips bereitgestellt, wobei die Solarzellen für die direkte Umwandlung von Sonnenenergie in elektrische Energie geeignete Oberflächenbereiche aufweist. Diese werden im weiteren als aktive Bereiche des Solarzellenchips bezeichnet.

Das erfindungsgemäße Verfahren basiert darauf, dass aus einem Wafer Solarzellenchips mittels eines Lasers in einer von der rechteckigen Form abweichenden Geometrie derart herausgeschnitten werden, dass die Anzahl der Solarzellenchips pro Wafer im Vergleich zu rechteckigen Solarzellenchips erhöht wird. Gleichzeitig wird die Geometrie der Solarzellenchips wie im Anspruch 1 angegeben gewählt, wobei auch ein kontinuierlicher Schneidevorgang des Lasers ermöglicht wird.

Dabei ist es bevorzugt, dass die Geometrie der aktiven Bereiche im Wesentlichen an die Geometrie des Solarzellenchips angepasst ist. Dieses Erfordernis ist nötig, um elektrische Kontaktierungen außerhalb der aktiven Bereiche des Solarzellenchips anordnen zu können, gleichzeitig aber auch einen möglichst hohen Anteil an aktiver Fläche pro Solarzellenchip zu realisieren. Die aktiven Bereiche der Solarzellenchips sind im Wesentlichen kreisförmig, d.h. der Kreisform angenähert. Es ist auch möglich, dass die Geometrie der aktiven Flächen eine elliptisch verformte Kreisform darstellt.

Der Laser wird beim Schneidevorgang so geführt, dass der herausgeschnittene Solarzellenchip im wesentlichen frei von geraden Schnittkanten, wie sie von im Stand der Technik üblichen Sägeprozessen bekannt sind.

Eine exemplarische Variante, die das Verständnis der Erfindung erleichtert, sieht vor, dass die Geometrie der Solarzellenchips im Wesentlichen hexagonal ist. Hierzu zählen insbesondere hexagonale Geometrien, bei denen die Ecken abgerundet sind. In diesem Fall ist es bevorzugt, dass die aktiven Bereiche der Solarzellenchips eine Übergangsform zwischen Kreisform und hexagonaler Form aufweisen. So können die aktiven Bereiche eine oktagonale, decagonale oder dodecagonale Geometrie aufweisen, wobei die Ecken so abgerundet sind, dass eine kontinuierliche Laserführung ermöglicht wird.

Erfindungsgemäß erfolgt die Laserführung zeilenförmig, wobei die Bewegung des Lasers im wesentlichen sinusförmig alterniert, d.h. der Laser fährt in Schlangenlinien die Zeile ab. Hierbei werden die Zeilen nacheinander durch Richtungsumkehr abgefahren, wobei sich die Scheitelpunkte der Sinuskurven in benachbarten Zeilen tangential berühren. Aus diesem Schnittmuster ergeben sich dann Solarzellenchips, die im Bereich der aktiven Flächen eine im wesentlichen kreisförmige Geometrie und an zwei gegenüberliegenden Seiten einen stegartigen Fortsatz aufweisen. Die stegartigen Fortsätze können dann für die elektrische Kontaktierung genutzt werden. Hierbei kann es sich z.B. um elliptische Formen handeln.

Ein weiteres Beispiel ist eine Form, bei der die aktiven Bereiche in einer dichtesten Kugelpackung, bezogen auf die Ebene des Solarzellenchips, angeordnet sind. Die hier verbleibenden Lücken der Kugelpackung werden dann als nicht-aktive Bereiche zur elektrischen Kontaktierung genutzt. Die Ausnutzung der Waferfläche ist in diesem Fall optimal.

Die Solarzellenchips weisen weiterhin erfindungsgemäß neben den aktiven Bereichen auch nicht-aktive oder passive Bereiche auf, indem zumindest bereichsweise elektrische Kontaktierungen angeordnet werden können. Vorzugsweise handelt es sich hierbei um zwei auf gegenüberliegenden Seiten des aktiven Bereichs liegende, punktförmige Kontaktierungen.

Die Vereinzelung des Wafers in Solarzellenchips erfolgt vorzugsweise mit einem YAG-Laser, einem Faserlaser und/oder einem Scheibenlaser. Der Laser kann dabei im trockenen Verfahren betrieben werden. Ebenso ist es möglich, dass der Laser in einen Flüssigkeitsstrahl eingekoppelt und mittels Totalreflexion geführt wird.

Der Schneidevorgang selbst erfolgt durch eine Relativbewegung von Wafer zu Laser. Hierbei kann es sich um eine Bewegung des Wafertisches, um eine fliegende Optik als Laser und/oder den Einsatz eines Laserscanners handeln.

Erfindungsgemäß wird ebenso ein Solarzellenchip mit einem aktiven, für die direkte Umwandlung von Sonnenenergie in elektrische Energie geeigneten Oberflächenbereich bereitgestellt, der nach dem zuvor beschriebenen Verfahren herstellbar ist.

Ebenso wird ein Solarzellenmodul bereitgestellt, das mindestens zwei und maximal 2000 Solarzellenchips enthält.

Anhand der nachfolgenden Figuren soll der erfindungsgemäße Gegenstand näher erläutert werden, ohne diesen auf die hier gezeigten speziellen Ausführungsformen einschränken zu wollen.
- Fig. 1: zeigt zwei Beispiele von Solarzellenchipgeometrien im Vergleich zu der aus dem Stand der Technik bekannten Geometrie.
- Fig. 2: zeigt eine Solarzellenchipgeometrie gemäß dem Stand der Technik.
- Fig. 3: zeigt eine exemplarische, nicht beanspruchte Solarzellen-chipgeometrie.
- Fig. 4: zeigt die erfindungsgemäße Solarzellenchipgeometrie.

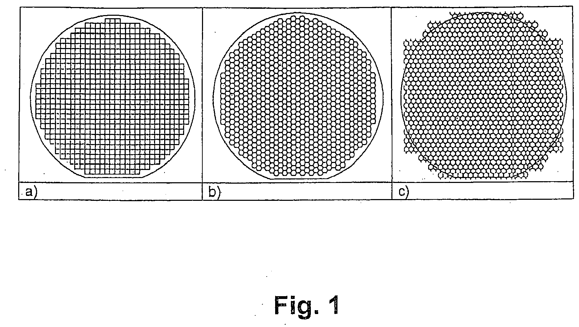

In Fig. 1a) wird eine aus dem Stand der Technik bekannte Geometrie dargestellt, bei der der Wafer in eine Vielzahl von Chipquadraten mittels Sägen vereinzelt wird. In Fig. 1b) ist eine Variante dargestellt, bei der eine hexagonale Anordnung der Solarzellenchips gewählt wird. Hierdurch kann die Anzahl der Chips auf dem Wafer um 16 % gesteigert werden. In Fig. 1c) ist ein weiteres Beispiel einer Geometrie dargestellt, die auf der sinusförmigen Bewegung des Lasers basiert, wodurch kontinuierliche Schneidewege realisiert werden. Hier ist die Anzahl der anzuordnenden Chips identisch zu der in Fig. 1b).

Den in Fig. 1 a)-c) dargestellten Solarzellen ist gemein, dass auf der Oberfläche zusätzliche Leiterbahnen (sog. Grid) angeordnet sind, um die an der Oberfläche einer Solarzelle gesammelten Ladungsträger abzuleiten.

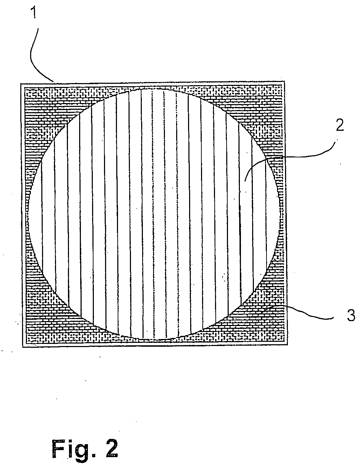

In Fig. 2 ist ein aus dem Stand der Technik bekannter Solarzellenchip mit entsprechendem Aufbau dargestellt. Hierbei handelt es sich um einen quadratischen Chip 1, der zentriert einen aktiven Bereich 2 aufweist. Weiterhin weist der Chip nicht-aktive Bereiche 3 auf, in denen die elektrische Kontaktierung erfolgen kann.

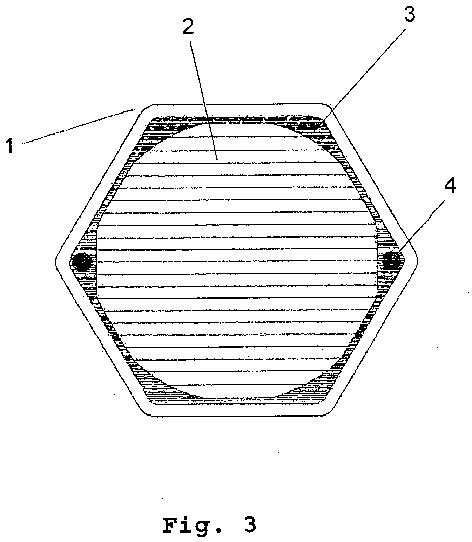

In Fig. 3 ist eine Variante basierend auf einem abgerundeten hexagonalen Chip 1 dargestellt. Auch dieser weist eine aktive Fläche 2 auf, wobei deren Form eine Kombination aus einem Polygon mit zwölf Ecken und einem Kreis ist, d.h. die Ecken wurden entsprechend abgerundet.

Weiterhin befinden sich auf dem Chip nicht-aktive Bereiche 3. Diese können dann für z.B. eine punktförmige elektrische Kontaktierung 4 genutzt werden.

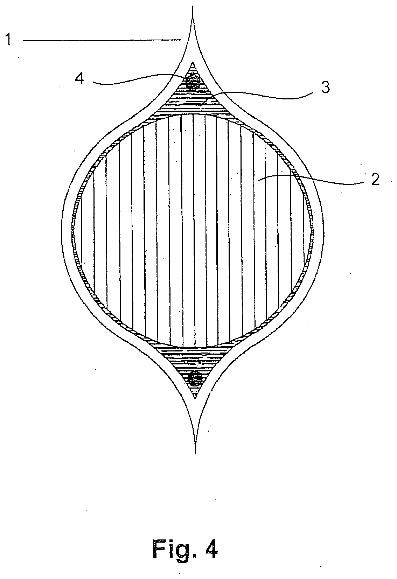

In Fig. 4 ist eine erfindungsgemäße Ausführung dargestellt, die auf einen Solarzellenchip mit tropfenähnlicher Geometrie 1 basiert. Bei dieser Variante fährt der Laser den Wafer zeilenartig ab, wobei am Zeilenende ein Versatz in die nächste Zeile und anschließende Richtungsänderung des Lasers erfolgt. Es handelt sich hier jedoch nicht um eine geradlinige, sondern um eine sinusartige Bewegung des Lasers. Dabei erfolgt das Abfahren so, dass der Solarzellenchip im Bereich der aktiven Fläche eine im Wesentlichen kreisförmige Geometrie und an zwei gegenüberliegenden Seiten einen stegartigen Fortsatz aufweist. Auf dem Solarzellenchip 1 ist dann ein aktiver Bereich 2 dargestellt, der in diesem Fall leicht elliptisch verformt ist. Weiterhin weist der Chip spitz zulaufende, nicht-aktive Bereiche 3 auf, in denen elektrische Kontaktierungen 4 angeordnet werden können. Diese Geometrie eignet sich besonders gut für die Verwendung von reflektiven oder massiven Sekundäroptiken, da die elektrischen Kontaktstellen einen vergleichsweise großen Abstand zur aktiven Zellfläche aufweisen.

## Patentansprüche

1. Verfahren zur Herstellung von Solarzellenchips (1) mit aktiven, für die direkte Umwandlung von Sonnenenergie in elektrische Energie geeigneten Oberflächenbereichen (2) und nicht-aktiven Bereichen (3), bei dem aus einem Wafer Solarzellenchips (1) mittels eines Lasers in einer von der rechteckigen Form abweichenden Geometrie derart herausgeschnitten werden, dass die Anzahl der Solarzellenchips (1) pro Wafer im Vergleich zu rechteckigen Solarzellenchips (1) erhöht wird, umfassend:
Kontaktieren der Solarzellenchips (1) in den nicht-aktiven Bereichen (3) bereichsweise mit elektrischen Kontaktierungen (4), insbesondere zwei auf gegenüberliegenden Seiten eines aktiven Oberflächenbereichs (2) liegenden, punktförmigen Kontaktierungen (4)
**gekennzeichnet durch**
Führen des Lasers zeilenförmig in einer im Wesentlichen sinusförmigen Bewegung derart, dass der Solarzellenchip (1) im aktiven Oberflächenbereich eine im Wesentlichen kreisförmige Geometrie und an zwei gegenüberliegenden Seiten davon einen stegartigen Fortsatz aufweist.

2. Verfahren nach Anspruch 1, wobei die Geometrie der aktiven Bereiche (2) im Wesentlichen an die Geometrie des Solarzellenchips (1) angepasst ist.

3. Verfahren nach Anspruch 2, wobei die kreisförmige Geometrie elliptisch verformt ist.

4. Verfahren nach einem der vorhergehenden Ansprüche, **dadurch gekennzeichnet, dass** als Laser ein YAG-Laser, ein Faserlaser und/oder ein Scheibenlaser eingesetzt wird.

5. Verfahren nach einem der vorhergehenden Ansprüche, **dadurch gekennzeichnet, dass** der Laser im Flüssigkeitsstrahl mittels Totalreflexion geführt oder im trockenen Verfahren betrieben wird.

6. Verfahren nach einem der vorhergehenden Ansprüche, **dadurch gekennzeichnet, dass** der Schneidevorgang durch eine Relativbewegung von Wafer zu Laser, insbesondere durch Bewegung des Wafertisches, mittels einer fliegenden Optik als Laser und/oder durch einen Laserscanner erfolgt.

7. Solarzellenchip (1) mit einem aktiven, für die direkte Umwandlung von Sonnenenergie in elektrische Energie geeigneten Oberflächenbereich (2) und nicht-aktiven Bereichen (3) sowie mit elektrischen Kontaktierungen (4), insbesondere zwei auf gegenüberliegenden Seiten eines aktiven Bereichs (3) liegenden, punktförmigen Kontaktierungen (4), wobei der Solarzellenchip (1) im aktiven Oberflächenbereich eine im Wesentlichen kreisförmige Geometrie und an zwei gegenüberliegenden Seiten davon einen stegartigen Fortsatz aufweist und nach einem der vorhergehenden Ansprüche herstellbar ist.

8. Solarzellenmodul enthaltend mindestens zwei und maximal 2000 Solarzellenchips (1) nach Anspruch 7.

## Claims

1. Method for the manufacture of solar cell chips (1) with active surface areas (2) suited for the direct conversion of solar energy into electric energy and non-active areas (3), wherein solar cell chips (1) are cut out of a waver by means of a laser in a geometry deviating from the rectangular shape, such that the number of solar cell chips (1) per wafer is increased compared to rectangular solar cell chips (1), comprising:
contacting the solar cell chips (1) in the non-active areas (3) by electric bondings (4), in particular, two punctual electric bondings (4) located on opposite sides of an active surface area (2),
**characterized by**
guiding the laser line-by-line in a substantially sinusoidal movement such that the solar cell chip (1) in the active surface area (2) exhibits a substantially circular geometric shape and web-like extensions at two opposite sides thereof.

2. Method according to claim 1, wherein the geometry of the active areas (2) is substantially adapted to the geometry of the solar cell chip.

3. Method according to one of the preceding claims, wherein the circular geometric shape is deformed elliptically.

4. Method according to one of the preceding claims, **characterized in that** a YAG laser, a fiber laser and/or a disk laser is employed as laser.

5. Method according to one of the preceding claims, **characterized in that** the laser is guided in the fluid jet by means of total reflection or operated in a dry process.

6. Method according to one of the preceding claims, **characterized in that** the cutting operation is accomplished by means of a relative movement between wafer and laser, in particular, by moving the wafer table by means of Flying Optics as laser and/or by a laser scanner.

7. Solar cell chip (1) with an active surface area suited for the direct conversion of solar energy into electric energy and non-active areas and with electric bondings (4), in particular, two punctual electric bondings (4) located on opposite sides of an active surface area (2), wherein the solar cell chip (1) exhibits in the active surface area (2) a substantially circular geometric shape and web-like extensions at two opposite sides thereof and is fabricable according to one of the preceding claims.

8. Solar cell module, containing at least two and at most 2000 solar cell chips (1) according to claim 7.

## Revendications

1. Procédé destiné à la fabrication de puces de cellules solaires ou photovoltaïques (1) avec des zones de surface actives (2), adaptées à la conversion directe d'énergie solaire en énergie électrique, et des zones non actives (3), procédé d'après lequel des puces de cellules solaires (1) sont découpées, au moyen d'un laser, dans une tranche de semi-conducteur appelée wafer, selon une géométrie qui diffère de la forme rectangulaire, de manière telle que le nombre de puces de cellules solaires (1) par tranche de semi-conducteur, soit augmenté par rapport à des puces de cellules solaires (1) de forme rectangulaire, le procédé comprenant :
la mise en contact des puces de cellules solaires (1) par endroits dans les zones non actives (3), avec des contacts électriques (4), notamment deux contacts (4) en forme de point, situés sur des côtés opposés d'une zone de surface active (2),
**caractérisé par**
le guidage du laser sous forme de ligne, selon un mouvement sensiblement de forme sinusoïdale, de façon telle que la puce de cellule solaire (1) présente, dans la zone de surface active, une géométrie sensiblement de forme circulaire et un prolongement en forme de patte sur deux côtés opposés de cette forme circulaire.

2. Procédé selon la revendication 1, d'après lequel la géométrie des zones actives (2) est sensiblement adaptée à la géométrie de la puce de cellule solaire (1).

3. Procédé selon la revendication 2, d'après lequel la géométrie de forme circulaire est déformée de manière elliptique.

4. Procédé selon l'une des revendications précédentes, **caractérisé en ce que** concernant le laser, on met en oeuvre un laser YAG, un laser à fibre et/ou un laser à disque.

5. Procédé selon l'une des revendications précédentes, **caractérisé en ce que** le laser est guidé par réflexion totale dans le jet de liquide, ou fonctionne selon un processus à sec.

6. Procédé selon l'une des revendications précédentes, **caractérisé en ce que** l'opération de découpe s'effectue par un mouvement de déplacement relatif de la tranche par rapport au laser, notamment par un mouvement de déplacement de la table de support de tranche, au moyen d'une optique flottante en tant que laser et/ou par un scanner laser.

7. Puce de cellule solaire (1) comprenant une zone de surface active (2), adaptée à la conversion directe d'énergie solaire en énergie électrique, et des zones non actives (3), ainsi que des contacts électriques (4), notamment deux contacts (4) en forme de point, situés sur des côtés opposés d'une zone active (2), la puce de cellule solaire (1) présentant, dans la zone de surface active, une géométrie sensiblement de forme circulaire et un prolongement en forme de patte sur deux côtés opposés de cette forme circulaire, et étant susceptible d'être fabriquée conformément à l'une des revendications précédentes.

8. Module de cellules solaires comportant au moins deux et au maximum 2000 puces de cellules solaires (1) selon la revendication 7.
